# EUROPÄISCHE PATENTSCHRIFT

(11) **EP 1 409 408 B1**
(45) Veröffentlichungstag und Bekanntmachung des Hinweises auf die Patenterteilung: **14.02.2007**
(21) Anmeldenummer: 02735240.0
(22) Anmeldetag: 09.04.2002
(51) Int. Cl.: C01B 35/04, H01L 39/12, C04B 41/88, C04B 35/58

(54) **METHODE ZUR HERSTELLUNG VON MAGNESIUMDIBORID SOWIE VON MAGNESIUMDIBORID-FORMKÖRPERN AUS MAGNESIUMHYDRID UND ELEMENTAREM BOR MITTELS PULS-PLASMA-SYNTHESE**
METHOD FOR PRODUCING MAGNESIUM DIBORIDE AND MAGNESIUM DIBORIDE MOULDED BODIES MADE FROM MAGNESIUM HYDRIDE AND ELEMENTARY BORON BY PULSE-PLASMA-SYNTHESIS
PROCEDE POUR PRODUIRE DU DIBORURE DE MAGNESIUM AINSI QUE DES CORPS MOULES EN DIBORURE DE MAGNESIUM A PARTIR D'HYDRURE DE MAGNESIUM ET DE BORE ELEMENTAIRE PAR SYNTHESE A PLASMA PULSE

(30) Priorität: 10.04.2001 DE 10117877
(43) Veröffentlichungstag der Anmeldung: 21.04.2004
(73) Patentinhaber: Max-Planck-Gesellschaft zur Förderung der Wissenschaften e.V., 80539 München (DE)
(72) Erfinder: SCHMIDT, Jürgen, 01187 Dresden (DE); GRIN, Yuri, 01309 Dresden (DE)
(74) Vertreter: Dey, Michael
(86) Internationale Anmeldenummer: PCT/EP2002/003952
(87) Internationale Veröffentlichungsnummer: WO 2002/083562

(56) Entgegenhaltungen:
- CN-A- 1 329 370
- NAGAMATSU J ET AL: "SUPERCONDUCTIVITY AT 39 K IN MAGNESIUM DIBORIDE" NATURE, MACMILLAN JOURNALS LTD. LONDON, GB, Bd. 410, 1. März 2001 (2001-03-01), Seiten 63-64, XP002948368 ISSN: 0028-0836 in der Anmeldung erwähnt
- ASWAL D K ET AL: "Synthesis and characterization of MgB2 superconductor" PHYSICA C, NORTH-HOLLAND PUBLISHING, AMSTERDAM, NL, Bd. 363, Nr. 3, 15. November 2001 (2001-11-15), Seiten 149-154, XP004311021 ISSN: 0921-4534
- KOLESNIKOV N N ET AL: "Synthesis of MgB2 from elements" PHYSICA C, NORTH-HOLLAND PUBLISHING, AMSTERDAM, NL, Bd. 363, Nr. 3, 15. November 2001 (2001-11-15), Seiten 166-169, XP004311023 ISSN: 0921-4534
- CUNNINGHAM C E ET AL: "Synthesis and processing of MgB2 powders and wires" PHYSICA C, NORTH-HOLLAND PUBLISHING, AMSTERDAM, NL, Bd. 353, Nr. 1-2, 1. Mai 2001 (2001-05-01), Seiten 5-10, XP004240410 ISSN: 0921-4534

## Beschreibung

Die vorliegende Erfindung betrifft ein Verfahren zur Herstellung von Magnesiumdiborid (MgB₂) sowie davon durch Austausch von Mg durch andere Metalle bzw. von B durch andere Nichtmetalle abgeleiteter Verbindungen sowie die Herstellung von Magnesiumdiborid-Formkörpern.

Kürzlich wurde festgestellt, dass Magnesiumdiborid eine hohe Supraleitungssprungtemperatur von 39 K aufweist (Nagamatsu et al., Nature 410 (2001), 63). Damit liegt seine Sprungtemperatur erheblich über der anderer einfacher intermetallischer Verbindungen (R. Cava, Nature 410 (2001), 23-24). Darüber hinaus ist Magnesiumdiborid mit einer Dichte von 2,6 gcm⁻³ erheblich leichter und zudem härter als andere intermetallische Verbindungen. Diese Kenndaten machen Magnesiumdiborid zu einem interessanten Konstruktionswerkstoff für supraleitende Bauteile geringer Dichte. Die Nutzung eines Materials für supraleitende Anwendungen erfordert im Allgemeinen die Herstellung entsprechender Formen, wie etwa Blöcke, Zylinder, Stäbe oder Drähte, mit einer gewissen mechanischen Festigkeit.

Aufgrund der vielfältigen Anwendungsmöglichkeiten für Magnesiumdiborid als Supraleiter besteht nunmehr ein dringender Bedarf an Herstellungsverfahren, die es ermöglichen, Magnesiumdiborid auf einfache aber kontrollierte Weise in reiner Form herzustellen.

Die meisten der bekannten Syntheseverfahren basieren auf einer Temperaturbehandlung eines Gemisches der Elemente Mg und Bor. Darüber hinaus kann Magnesiumdiborid in einer Festkörperreaktion in einer Inertgasatmosphäre, z.B. Argon, hergestellt werden. Bei den herkömmlichen Verfahren werden Mischungen aus Magnesium und Bor in fein verriebenem Zustand in Anwesenheit eines Schutzgases bei hohen Temperaturen zur Reaktion gebracht. Zur Herstellung von Formkörpern wird die Mischung dann vor oder während der Reaktion gepresst (vgl. z.B. V. Russel et al., Acta Cryst. 6 (1953), 870). Es ist aber auch möglich, Magnesiumdiborid durch Redoxreaktionen aus geeigneten Verbindungen herzustellen, beispielsweise aus einer Mischung aus Borcarbid und Magnesium (DE 1 229 505).

Eine Aufgabe der Erfindung war es, ein verbessertes Verfahren zur Herstellung von Magnesiumdiborid und ähnlicher Verbindungen bereitzustellen.

Diese Aufgabe wird erfindungsgemäß gelöst durch ein Verfahren zur Herstellung einer Verbindung der Formel (I) Mg₁₋ₓMe_{y}B_{2-z}Eeᵥ, worin
- Me =: ein oder mehrere Elemente ausgewählt aus den Metallen, insbesondere den Alkalimetallen, Erdalkalimetallen, Übergangsmetallen, Erdmetallen und Seltenerdmetallen,
- Ee =: ein oder mehrere Elemente ausgewählt aus den Nichtmetallen, insbesondere den Nichtmetallen der Gruppen 13, 14 und 15 des Periodensystems der Elemente,
- x =: 0 bis 0,5,
- y =: 0 bis 1,
- z =: 0 bis 1 und
- v =: 0 bis 1,
dadurch gekennzeichnet, dass man Magnesiumhydrid und gegebenenfalls Me-Hydrid oder/und Me mit Bor und gegebenenfalls mit Ee umsetzt.

Überraschenderweise kann durch die Verwendung von Magnesiumhydrid bei der Herstellung von Magnesiumdiborid eine deutliche Verbesserung des Herstellungsverfahrens und insbesondere eine höhere Reinheit der Endprodukte erhalten werden. Bei Verwendung von metallischem Magnesium, wie bei den Verfahren im Stand der Technik beschrieben, bildet sich auf dem Ausgangsmaterial, insbesondere falls Magnesiumpulver verwendet wird, eine Oxidschicht. Dies führt jedoch zur Einbringung von Sauerstoff und damit von Verunreinigungen in das gewünschte Produkt. Weiterhin ist es beim erfindungsgemäßen Verfahren unter Verwendung von Magnesiumhydrid im Gegensatz zu Verfahren unter Verwendung von metallischem Magnesium nicht erforderlich, das metallische Magnesium zu schmelzen, wodurch Verluste an Magnesium und damit Veränderungen in der gewünschten Stöchiometrie des Endprodukts ausgeschlossen werden können. Bei dem erfindungsgemäßen Verfahren handelt es sich somit um ein gut kontrollierbares Herstellungsverfahren, mit dem das gewünschte Produkt in hoher Reinheit und der gewünschten Stöchiometrie erhalten werden kann.

Das erfindungsgemäße Verfahren kann zur Herstellung einer Verbindung der Formel (II) Mg₁₋ₓMₓB_{2-z}E_{z}, eingesetzt werden, worin M die oben angegebenen Bedeutungen für Me und E die oben angegebenen Bedeutungen für Ee aufweisen kann. E kann dabei ein einzelnes Element sein oder eine Gruppierung von Elementen.

In einer besonders bevorzugten Ausführungsform wird das erfindungsgemäße Verfahren verwendet, um reines MgB₂ aus MgH₂ und B herzustellen, insbesondere MgB₂, welches einen Gehalt an Verunreinigungen von ≤ 1 Gew. %, bevorzugt ≤0,1 Gew. %, mehr bevorzugt 0,01 Gew. % bezogen auf das Gesamtgewicht von MgB₂ enthält. Insbesondere ist es mit dem erfindungsgemäßen Verfahren möglich, ein Sauerstoff-freies oder praktisch Sauerstoff-freies MgB₂ mit einem Gehalt an Sauerstoff ≤0,1 Gew. %, mehr bevorzugt ≤0,01 Gew. % und am meisten bevorzugt ≤0,001 Gew. % bezogen auf das Gesamtgewicht des Magnesiumdiborids herzustellen.

Es ist aber auch möglich, intermetallische Verbindungen zu erhalten, in dem ein Teil des Magnesium durch ein oder mehrere andere Metalle, insbesondere ausgewählt aus den Alkalimetallen, beispielsweise Lithium, Natrium, Kalium oder Rubidium, den Erdalkalimetallen, beispielsweise Beryllium, Kalzium, Strontium oder Barium, den Übergangsmetallen, den Erdmetallen, insbesondere Aluminium, Scandium, Yttrium, Lanthan und den Seltenerdmetallen. Das Element Me bzw. das Element M kann an die Verbindung eingebracht werden, in dem man dem Ausgangsgemisch aus Magnesiumhydrid und Bor ein Hydrid des Metalls Me bzw. M oder/und elementares Me oder/und M zumischt. Die gewünschte Stöchiometrie des Endprodukts wird auf einfache Weise durch Einstellen der Stöchiometrie in den Ausgangsmaterialien erzielt.

Weiterhin ist es möglich, einen Teil des Bors in der Verbindung der Formel (I) durch ein anderes Nichtmetall, insbesondere durch Nichtmetalle der Gruppen 13, 14 und 15 des Periodensystems der Elemente (die Bezeichnung erfolgt nach neuer IUPAC-Nomenklatur) zu ersetzen, insbesondere durch p-Elemente. Beispiele für Ee sind Si, P und As.

x beträgt bevorzugt 0 (in diesem Fall enthält die Verbindung der Formel (I) kein weiteres Metall neben Magnesium), kann aber auch mindestens 0,01, mehr bevorzugt mindestens 0,1 und bis zu 0,5, mehr bevorzugt bis zu 0,2 betragen. z beträgt bevorzugt 0 (in diesem Fall ist in der Verbindung der Formel (I) kein weiteres Nichtmetall neben Bor enthalten), kann aber auch mindestens 0,01, mehr bevorzugt mindestens 0,1 und bis 1, mehr bevorzugt bis zu 0,5 und am meisten bevorzugt bis zu 0,3 betragen. Neben der Herstellung von intermetallischen Verbindungen oder Hybridmaterialien ist es erfindungsgemäß aber auch möglich, "dotiertes" Magnesiumdiborid herzustellen, als Magnesiumdiborid, welches einen geringen Anteil an anderen Metallen oder/und Nichtmetallen, beispielsweise einen Gehalt von 0,01 bis 5 mol%, mehr bevorzugt von 0,1 bis 3 mol% an Me oder/und Ee aufweist.

In einer besonders bevorzugten Ausführungsform betrifft die Erfindung ein Verfahren zur Herstellung einer Verbindung der Formel (I) Mg₁₋ₓMe_{y}B_{2-z}Eeᵥ, worin
- Me =: ein oder mehrere Elemente ausgewählt aus den Metallen, insbesondere den Alkalimetallen, Erdalkalimetallen, Übergangsmetallen, Erdmetallen und Seltenerdmetallen,
- Ee =: ein oder mehrere Elemente ausgewählt aus den Nichtmetallen, insbesondere den Nichtmetallen der Gruppen 13, 14 und 15 des Periodensystems der Elemente,
- x =: 0 bis 0,5,
- y =: 0 bis 1,
- z =: 0 bis 1 und
- v =: 0 bis 1,
dadurch gekennzeichnet, dass man eine Mg-haltige Verbindung und gegebenenfalls eine Me-haltige Verbindung mit einer B-haltigen Verbindung und gegebenenfalls einer Ee-haltigen Verbindung mittels Puls-Plasma-Synthese umsetzt. Mit der Puls-Plasma-Synthese kann auch eine Verbindung der Formel (II) Mg₁₋ₓMₓB_{2-z}E_{z} hergestellt werden, worin M und E die oben angegebenen Bedeutungen aufweisen können.

Die Plasma-Puls-Synthese ist ein Verfahren, welches es erlaubt, ein Pulvergemisch umfassend mindestens eine magnesiumhaltige und mindestens eine borhaltige Verbindung zu Magnesiumdiborid umzusetzen. Dazu wird das Pulvergemisch in die Vertiefung einer Pressmatritze, beispielsweise einer zylindrischen Graphit- oder Hartmetallpressmatritze, gefüllt und zwischen zwei Stempeln aus gleichem Material gepresst. Die Synthese und Herstellung kann dabei unter verschiedenen Gesamtdrücken, bevorzugt zwischen 1 x 10⁻² Pa und 5 x 10⁵ Pa, bevorzugt bis zu 2 x 10⁵ Pa, erfolgen. Nach Befüllen mit dem Pulvergemisch wird das Presswerkzeug in die gewünschte Reaktionsatmosphäre, beispielsweise Vakuum oder ein übliches Schutzgas, wie etwa Argon oder Stickstoff gebracht. Zwischen beiden Stempeln wird ein gepulster Strom angelegt, um Funken innerhalb des Pulvers zwischen den Partikeloberflächen zu erzeugen. Der gepulste Strom weist üblicherweise ein Stärke von mindestens 1 A, mehr bevorzugt von mindestens 100 A und bis zu 2000 A, mehr bevorzugt bis zu 1000 A auf. Die Spannung beträgt dabei bevorzugt 0,5-300 V, insbesondere 1-25 Volt. Die Funken und die durch den Stromfluss entstehende Joule'sche Wärme erhitzen den Pressling und die Matritze. Die Funken entstehen in der Nähe von Oberflächenkontaktpunkten der einzelnen Pulverpartikel und an Korngrenzen innerhalb einzelner Partikel. Durch dieses lokale Auftreten von hohen Temperaturen kommt es zu einer Entfernung von adsorbierten Gasen, zu einer Zerstörung von passivierenden Oberflächenschichten (z.B. oberflächlichen Oxidschichten) und begünstigt durch den Druck auf das Presswerkzeug zu einem Verschweißen an diesen Punkten. Dies führt zu einer erheblichen Beschleunigung des Sintervorgangs und zu einer hohen Dichte des Sinterkörpers.

Oberhalb der Reaktionstemperatur kommt es zu einer Umsetzung von Magnesiumhydrid und Bor zu Magnesiumdiborid. Die Umsetzung folgt der Bruttogleichung:

MgH₂ + 2 B → MgB₂ + H₂

Der entstehende Wasserstoff entweicht kontinuierlich aus dem Presswerkzeug. Das entstehende Produkt ist ohne erkennbare Risse dicht gesintert.

Überraschenderweise wurde bei der vorliegenden Erfindung festgestellt, dass das Puls-Plasma-Verfahren, welches auch Spark-Plasma-Prozess oder Spark-Plasma-Sintering genannt wird und üblicherweise zum Sintern und Verdichten von Materialien eingesetzt wird, herangezogen werden kann, um Magnesiumdiborid aus pulverförmigen Ausgangsmaterialien herzustellen. Der Spark-Plasma-Prozess ist beispielsweise beschrieben im US-Patent Nr. 3,241,956 , US-Patent Nr. 3,250,982 , WO00/58235, EP 104 31 49, EP 104 08 86, JP 1025 1057, JP 1205 1070, JP 1019 4859, JP 5001 304, JP 6287 076 und JP 7216 409.

Die Vorteile des erfindungsgemäßen Verfahrens gegenüber den bekannten Synthesemethoden von Magnesiumdiborid und anderen üblichen metallurgischen Verfahren zur Herstellung von gesinterten Formkörpern, wie z.B. Heißpressen oder heißisostatischem Pressen, sind insbesondere folgende:
- Es können sowohl die Synthese des Werkstoffs (Magnesiumdiborid) als auch die pulvermetallurgische Herstellung von Formkörpern in einem einzigen Schritt zusammengefaßt werden.
- Die Ausbildung von gewünschten Gefügeeigenschaften kann durch die Teilchengröße der eingesetzten Pulver sowie durch Variation der Syntheseparameter, insbesondere Temperatur, Druck und Zeit auf einfache Weise eingestellt werden.
- Die Arbeitstemperatur kann im Rahmen der Puls-Plasma-Synthese niedrig, insbesondere <900 °C gehalten werden. Dies hat den Vorteil, dass es während des Prozesses nur zu minimalen oder keinen Verlusten an Magnesium kommt und so die Zusammensetzung der Probe auf einfache Weise durch Einstellen der Zusammensetzung der Ausgangsmaterialien kontrolliert werden kann.
- Es kann ohne Bindemittel und Sinterhilfsmittel gearbeitet werden, so dass keine unerwünschte Verunreinigung mit Fremdstoffen auftritt.
- Die Puls-Plasma-Synthese bewirkt im Produkt eine sehr hohe Verdichtung des gesinterten Formkörpers innerhalb sehr kurzer Herstellungszeiten. Hohe Dichten erlauben aber hohe Werte für die kritische Stromstärke in einem Supraleiter, oberhalb der die Supraleitung abnimmt.

In einer besonders bevorzugten Ausführungsform wird das erfindungsgemäße Verfahren mittels der Puls-Plasma-Synthese unter Verwendung von Magnesiumhydrid (MgH₂) oder/und elementarem Magnesium (Mg), d.h. von MgH₂ oder Gemischen aus MgH₂ und Mg, am meisten bevorzugt unter Verwendung von Magnesiumhydrid als Ausgangsmaterial durchgeführt. Bei der Verwendung von Magnesiumhydrid kann die Verunreinigung durch Sauerstoff auf der Oberfläche der Ausgangsmaterialien, wie sie beispielsweise bei Einsatz von metallischem Magnesium auftreten kann, vollständig vermieden werden.

Weiterhin wurde festgestellt, dass eine gewünschte Zusammensetzung durch einfaches Zusammenmischen von Ausgangsmaterialien in der gewünschten Stöchiometrie gebildet werden kann. Bei der chemischen Umsetzung der Ausgangsstoffe mittels Puls-Plasma-Synthese werden dann die gewünschten Phasen erhalten.

Als besonders vorteilhafte Verfahrensparameter zur Durchführung der Puls-Plasma-Synthese bei der Herstellung von Magnesiumdiborid oder davon durch teilweises Ersetzen des Magenesium oder/und teilweises Ersetzen des Bors erhaltenen Hybridmaterialien haben sich Pulse mit einer Stromstärke von > 10 A, mehr bevorzugt > 100 A, mehr bevorzugt > 200 A und bis zu 2000 A, mehr bevorzugt bis zu 1000 A erwiesen. Die maximale Spannung der Pulse beträgt bevorzugt 1-300, mehr bevorzugt 1,5-5 V. Besonders bevorzugt wird Gleichstrom angelegt, wodurch es zu einer Diffusion und damit zu einer großen Homogenität des erhaltenen-Materials kommt.

Die Pulsdauer der Strompulse beträgt bevorzugt 1 ms bis 10 ms, mehr bevorzugt 2-5 ms. Es ist aber auch möglich, längere oder kürzere Pulse anzulegen. Insbesondere ist es möglich, die Dauer zwischen den Pulsen beliebig einzustellen, beispielsweise zwischen 1 und 100 ms, mehr bevorzugt zwischen 2 und 10 ms.

Bevorzugte Parameter des erfindungsgemäßen Verfahrens sind beispielsweise Pulse mit einer Stärke von 1 bis 2000 A, einer Länge von 1 bis 10 ms und einer Frequenz von 1 bis 1000 Hz.

Durch das gepulste Anlegen des Stroms kann eine niedrige mittlere Verfahrenstemperatur, beispielsweise ≤900 °C, mehr bevorzugt ≤750 °C eingehalten werden, bei der ein Verdampfen von Magnesium vermieden wird, während gleichzeitig durch lokal auftretende hohe Temperaturen die Reaktionstemperatur zur Umsetzung der Ausgangsmaterialien zum gewünschten Produkt, insbesondere einer Magnesiumdiboridphase, erreicht wird.

Das erfindungsgemäße Verfahren wird weiterhin bevorzugt bei einem Reaktionsdruck von 1 bis 1000 bar durchgeführt.

Das erfindungsgemäße Verfahren, insbesondere unter Verwendung der Puls-Plasma-Synthese, wird bevorzugt in einer Atmosphäre durchführt, in der die Bildung von unerwünschten Verunreinigungen ausgeschlossen wird. Bevorzugt wird das Verfahren unter Vakuum oder in einer Schutzgasatmosphäre, beispielsweise einer Edelgasatmosphäre und insbesondere unter Neon, Argon oder Stickstoff durchgeführt. Das Schutzgas kann unter erhöhtem Druck, beispielsweise einem Überdruck von bis zu 5 bar gestellt werden, um einem Abdampfen gewünschter Bestandteile, beispielsweise einem Abdampfen von Magnesium, weiter entgegen zu wirken.

Gasförmige Stoffe, beispielsweise während der Umsetzung gebildeter Wasserstoff sowie gegebenenfalls an den Oberflächen der Ausgangsmaterialien adsobierte Gase, entweichen während der Reaktion kontinuierlich und können somit ohne Weiteres entfernt werden.

Mit dem erfindungsgemäßen Verfahren ist es möglich, Magnesiumdiborid oder davon abgeleitete Materialien der Formel (I) als Pulver, insbesondere als Pulver mit hoher Reinheit und geringer Verunreinigung an unerwünschten Elementen, wie beispielsweise Sauerstoff, Kohlenstoff oder Stickstoff, zu erhalten.

Besonders bevorzugt ist es jedoch, mit dem erfindungsgemäßen Verfahren, insbesondere mittels Puls-Plasma-Synthese, einen Formkörper bestehend aus einer Verbindung der Formel (i) herzustellen. Unter Verwendung der Puls-Plasma-Synthese können die zwei Schritte chemische Umsetzung und Verdichtung in einem einzigen Verfahrensschritt durchgeführt werden.

Darüber hinaus kann eine kontrollierte und konstante Zusammensetzung einer Verbindung der Formel (I) über den gesamten Formkörper bzw. Pressling erhalten werden. Der erfindungsgemäße Formkörper weist bevorzugt eine Größe von mindestens 0,1 mm, mehr bevorzugt mindestens 1 mm und besonders bevorzugt mindestens 5 mm in mindestens einer, bevorzugt in jeder Dimension auf. Es ist aber auch möglich, Formkörper herzustellen, die in einer Dimension eine Größe von mindestens 20 mm, mehr bevorzugt mindestens 50 mm aufweisen.

Neben der direkten Herstellung von Formkörpern in einem Schritt mittels der Puls-Plasma-Synthese ist es auch möglich, eine zunächst durch Umsetzung von Magnesiumhydrid erhaltene pulverförmige Verbindung der Formel (I) nachträglich durch bekannte Sinterverfahren oder metallurgische Verfahren zu verdichten, beispielsweise durch Heißpressen oder heißisostatisches Pressen.

Die erfindungsgemäß erhaltenen Formkörper können dichte Strukturen aufweisen, die ≥50 % der theoretischen Dichte, mehr bevorzugt ≥80 % der theoretischen Dichte und am meisten bevorzugt ≥90 % der theoretischen Dichte (pyknometrisch) aufweisen. Durch geeignete Wahl der Reaktionsbedingungen, beispielsweise einen verringerten Druck, können auch poröse Strukturen und insbesondere mikroporöse Strukturen erhalten werden. Mikroporöse Strukturen werden mittels Puls-Plasma-Synthese, insbesondere bei einem Druck ≤5 bar hergestellt.

Während es, wie oben beschrieben, mit dem erfindungsgemäßen Verfahren möglich und bevorzugt ist, direkt Hybridmaterialien herzustellen, nämlich durch Zumischung entsprechender Me oder Ee enthaltender Ausgangsmaterialien zum Reaktionsgemisch, beispielsweise durch Zumischung von Kupfer zu Magnesiumhydrid und Bor, können Hybridmaterialien auch durch Infiltrieren der erfindungsgemäß herstellbaren porösen Formkörper mit Metallen oder/und Metalllegierungen- erhalten werden. Beide Methoden können verwendet werden, um von Magnesiumdiborid abgeleitete Verbindungen der Formel (I) mit verbesserten Eigenschaften, insbesondere mit verbesserten Supraleitereigenschaften, zu bilden.

Weiterhin ist es durch das erfindungsgemäße Herstellungsverfahren möglich, Verbindungen der Formel (I) und insbesondere Magnesiumdiborid als Einphasenmaterial herzustellen, welches eine hohe Homogenität und eine hohe Reinheit aufweist.

Der Erfindung betrifft deshalb weiterhin eine Verbindung der Formel (1) Mg₁₋ₓMe_{y}B_{2-z}Eeᵥ, worin
- Me =: ein oder mehrere Elemente ausgewählt aus den Metallen, insbesondere den Alkalimetallen, Erdalkalimetallen, Übergangsmetallen, Erdmetallen und Seltenerdmetallen,
- Ee =: ein oder mehrere Elemente ausgewählt aus den Nichtmetallen, insbesondere den Nichtmetallen der Gruppen 13, 14 und 15 des Periodensystems der Elemente,
- x =: 0 bis 0,5,
- y =: 0 bis 1,
- z =: 0 bis 1 und
- v =: 0 bis 1,
dadurch gekennzeichnet, dass sie einen Sauerstoffgehalt von ≤ 1 Gew. %, insbesondere ≤0,1 Gew. % bezogen auf das Gesamtgewicht der Verbindung der Formel (I) aufweist. Durch die Wahl des Ausgangsmaterials kann auch der Sauerstoffgehalt im Endprodukt gering gehalten werden, wobei durch die Gegenwart von Sauerstoff hervorgerufene Beeinträchtigungen der gewünschten Eigenschaften, insbesondere der Supraleitfähigkeit, ausgeräumt werden können. Bevorzugt ist x oder/und y ≥0.

Ein weiterer Aspekt der vorliegenden Erfindung ist ein Formkörper, welcher eine Verbindung der obigen Formel (I) umfasst, welcher neben dem oben beschriebenen geringen Sauerstoffgehalt bei Temperaturen ≥ 30 K supraleitfähige Eigenschaften zeigt.

Die Erfindung betrifft weiterhin einen Formkörper, der aus einer Verbindung der Formel (I) gebildet ist und neben der diskutierten Sauerstofffreiheit eine hohe Homogenität aufweist. Eine hohe Homogenität im Sinne der vorliegenden Erfindung liegt dann vor, wenn man einen Würfel mit einer Einheitskantenlänge betrachtet, aus diesem Würfel mit Einheitskantenlänge Teilwürfel mit einer Kantenlänge von 1:10 Einheitskantenlänge bildet und die Abweichung der Zusammensetzung der einzelnen Teilwürfel vom Mittel aller Teilwürfel ≤ 30 %, bevorzugt ≤ 20 % ist.

Die Formkörper werden bevorzugt in Form von Blöcken, Stäben oder Drähten hergestellt, um einen Einsatz als Supraleiter zu erleichtern. Insbesondere durch die Zumischung weiterer Metalle neben Magnesium bzw. weiterer Nichtmetalle neben Bor sowie durch die hohe Reinheit und die Einphasenstruktur zeigen die erfindungsgemäßerhaltenen Verbindungen der Formel (I) verbesserte supraleitende Eigenschaften.

Somit betrifft die vorliegende Erfindung die Verwendung einer Verbindung der obigen Formel (I), welche den oben beschriebenen geringen Sauerstoffgehalt aufzeigt, oder eines Formkörpers, welcher eine solche Verbindung umfasst, als Supraleiter.

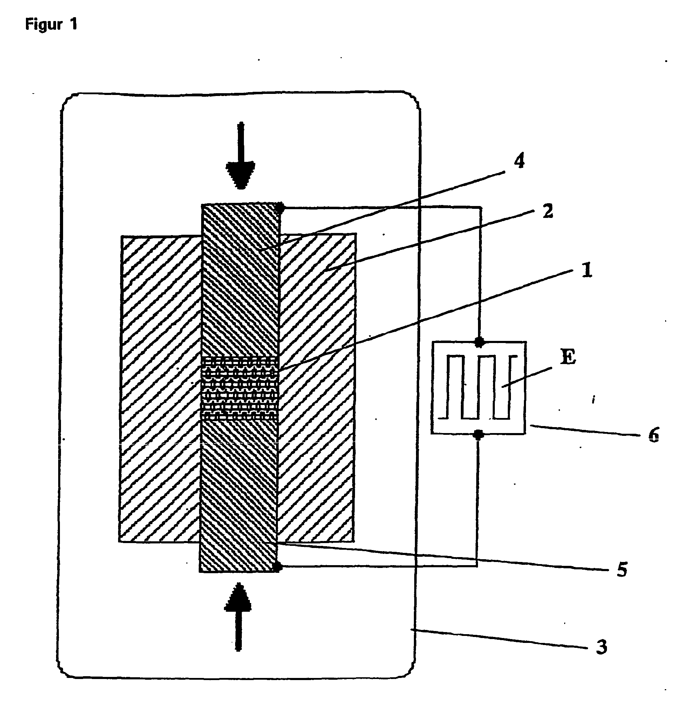

Die Erfindung wird durch die beigefügte Figur und die nachfolgenden Beispiele weiter erläutert.

### Figur 1

zeigt eine schematische Darstellung einer Puls-Plasma-Synthese Anlage. Eine Pulvermischung 1, beispielsweise bestehend aus Magenesiumhydrid und Bor, wird in die zylindrische Öffnung einer Pressmatritze aus Graphit oder Hartmetall 2 gefüllt, welche sich in einer Vakuum-/ Schutzgaskammer 3 befindet. Zwei Pressstempel 4 und 5 aus dem gleichen Material wie die Matritze 2 werden in diese durch die beiden gegenüber liegenden

Öffnungen hineingesteckt und so angeordnet, dass das Material 1 zwischen beiden Stirnseiten der Stempel gepresst werden kann, wenn diese mit einer Presse (nicht abgebildet) verbunden werden. An den freien Enden der Stempel kann ein gepulster elektrischer Strom angelegt werden, welcher im Generator 6 erzeugt wird. Während der Puls-Plasma-Synthese befindet sich in der Kammer 3 Schutzgas mit entsprechend gewähltem Druck oder es wird ein Vakuum angelegt. Die Pressstempel 4 und 5 werden gegen die Pulvermischung 1 gepresst. Dabei fließt ein elektrischer Strom mit einer zyklisch gepulsten Spannung E durch die Pressstempel 4 und 5. Diese werden zusammen mit der zylindrischen Pressmatritze und der vom Strom durchflossenen Pulvermischung 1 durch den fließenden Strom erhitzt und zur gleichen Zeit durch die äußere Kraft der Presses kompaktiert, bis das Sintern abgeschlossen ist.

### Beispiele:

### Beispiel 1: Synthese von Magnesiumdiborid

Magnesiumdiborid wurde aus den Ausgangsmaterialien Magnesiumhydrid (MgH₂) und Bor (B) unter Bildung von Magnesiumdiborid (MgB₂) und Wasserstoff (H₂) hergestellt. Dazu wurde MgH₂ in Pulverform und amorphes B-Pulver mit einer mittleren Teilchengröße von 10 *µ*m in einem molaren Verhältnis von MgH₂:B = 1:2 vermischt. Das Pulvergemisch der Ausgangsmaterialien wurde in einem Spark-Plasma-Sintering-System (Dr. Sinter^{®}SPS-515S, Sumitomo Coal Mining Co., Ltd., Japan) umgesetzt. Das Pulver wurde in einer Kohlenstoffmatritze gepresst und es wurde ein gepulster Gleichstrom angelegt. Neben den Verteilen des Heiß-Druck-Sinterns ist ein wesentliches Merkmal der Puls-Plasma-Synthese die Erwärmung des Pulvers durch Pulsentladungen zwischen den Pulverteilchen. Als Folge wird die Probe umgesetzt und gleichmäßig und schnell über das gesamte Volumen gesintert.

Das Pulvergemisch wurde von Raumtemperatur auf 750 °C in einer Stunde erwärmt und dann bei dieser Temperatur 30 Minuten unter fortgesetztem Anlegen von Strompulsen behandelt. Die Synthese wurde unter Argon als Schutzgas durchgeführt.

XRD-Muster der hergestellten Pellets zeigten Reflexionen von Magnesiumdiborid. Eine Verunreinigung durch Graphit von der Matritze wurde nicht beobachtet. Es wurde ein Einphasen-Magnesiumdiborid direkt aus einem pulverförmigen Gemisch aus Magnesiumhydrid und elementarem Bor durch Plasma-Puls-Synthese synthetisiert.

## Patentansprüche

1. Verfahren zur Herstellung einer Verbindung der Formel (I)
Mg₁₋ₓMe_{y}B_{2-z}Eeᵥ, worin
Me = ein oder mehrere Elemente ausgewählt aus den Metallen, insbesondere den Alkalimetallen, Erdalkalimetallen, Übergangsmetallen, Erdmetallen und Seltenerdmetallen,
Ee = ein oder mehrere Elemente ausgewählt aus den Nichtmetallen, insbesondere den Nichtmetallen der Gruppen 13, 14 und 15 des Periodensystems der Elemente,
x = 0 bis 0,5,
y = O bis 1,
z = O bis 1 und
v = O bis 1,
**dadurch gekennzeichnet,**
**dass** man Magnesiumhydrid und gegebenenfalls Me-Hydrid oder/und Me mit Bor und gegebenenfalls mit Ee umsetzt.

2. Verfahren nach Anspruch 1,
**dadurch gekennzeichnet,**
**dass** man MgB₂ durch Umsetzung von MgH₂ und B herstellt.

3. Verfahren zur Herstellung einer Verbindung der Formel (I)
Mg₁₋ₓMe_{y}B_{2-z}Eeᵥ, worin
Me = ein oder mehrere Elemente ausgewählt aus den Metallen, insbesondere den Alkalimetallen, Erdalkalimetallen, Übergangsmetallen, Erdmetallen und Seltenerdmetallen,

4. Verfahren nach Anspruch 3,
**dadurch gekennzeichnet,**
**dass** man als Ausgangsmaterialien MgH₂ oder Gemische aus MgH₂ und Mg und gegebenenfalls Me-Hydrid oder/und Me sowie elementares Bor und gegebenenfalls elementares Ee einsetzt.
Ee = ein oder mehrere Elemente ausgewählt aus den Nichtmetallen, insbesondere den Nichtmetallen der Gruppen 13, 14 und 15 des Periodensystems der Elemente,
x = 0 bis 0,5,
y = 0 bis 1,
z = 0 bis 1 und
v = 0 bis 1,
**dadurch gekennzeichnet,**
**dass** man eine Mg-haltige Verbindung und gegebenenfalls eine Me-haltige Verbindung mit einer B-haltigen Verbindung und gegebenenfalls einer Ee-haltigen Verbindung mittels Puls-Plasma-Synthese umsetzt.

5. Verfahren nach einem der Ansprüche 3 oder 4,
**dadurch gekennzeichnet,**
**dass** man als eines der Ausgangsmaterialien MgH₂ einsetzt.

6. Verfahren nach einem der vorhergehenden Ansprüche,
**dadurch gekennzeichnet,**
**dass** man die Ausgangsmaterialien in der Stöchiometrie des herzustellenden Produkts einsetzt.

7. Verfahren nach einem der Ansprüche 3 bis 6,
**dadurch gekennzeichnet,**
**dass** an die Ausgangsmaterialien Pulse mit einer Stärke von 1 bis 2000 A, einer Länge von 1 bis 10 ms und einer Frequenz von 1 bis 1000 Hz angelegt werden.

8. Verfahren nach einem der vorhergehenden Ansprüche,
**dadurch gekennzeichnet,**
**dass** die Umsetzung bei einer Reaktionstemperatur von ≤900 °C durchgeführt wird.

9. Verfahren nach einem der vorhergehenden Ansprüche,
**dadurch gekennzeichnet,**
**dass** die Umsetzung bei einem Reaktionsdruck von 1 bis 1000 bar durchgeführt wird.

10. Verfahren nach einem der vorhergehenden Ansprüche,
**dadurch gekennzeichnet,**
**dass** man die Umsetzung unter einer Inertgasatmosphäre durchführt.

11. Verfahren nach einem der vorhergehenden Ansprüche,
**dadurch gekennzeichnet,**
**dass** man die Verbindung der Formel (I) in Pulverform herstellt.

12. Verfahren zur Herstellung eines Formkörpers, umfassend ein Verfahren nach einem der vorhergehenden Ansprüche 1 bis 10, weiterhin umfassend den Schritt:
Herstellen eines aus einer Verbindung der Formel (I) gebildeten Formkörpers.

13. Verfahren zur Bildung eines Formkörpers, umfassend ein Verfahren nach Anspruch 11, weiterhin umfassend den Schritt Pulververdichten des erhaltenen Pulvers, um einen Formkörper zu bilden.

14. Verfahren nach einem der Ansprüche 1 bis 10 und 12 bis 13,
**dadurch gekennzeichnet,**
**dass** eine Struktur hergestellt wird, die ≥ 50 % der theoretischen Dichte aufweist.

15. Verfahren nach einem der Ansprüche 1 bis 10 oder 12 bis 13,
**dadurch gekennzeichnet,**
**dass** eine poröse Struktur hergestellt wird.

16. Verfahren nach Anspruch 15,
**dadurch gekennzeichnet,**
**dass** eine poröse Struktur mittels einer Puls-Plasma-Synthese bei einem Druck von ≤5 bar erhalten wird.

17. Verfahren nach Anspruch 15,
**dadurch gekennzeichnet,**
**dass** die poröse Struktur durch Sintern von MgB₂-Pulver erhalten wird.

18. Verfahren zur Herstellung einer infiltrierten porösen Struktur, umfassend ein Verfahren nach einem der Ansprüche 15 bis 17, weiterhin umfassend den Schritt:
Infiltrieren der porösen Struktur mit mindestens einem Metall oder/und einer Metalliegierung.

19. Verbindung der Formel (I)
Mg₁₋ₓMe_{y}B_{2-z}Eeᵥ, worin
Me = ein oder mehrere Elemente ausgewählt aus den Metallen, insbesondere den Alkalimetallen, Erdalkalimetallen, Übergangsmetallen, Erdmetallen und Seltenerdmetallen,
Eₑ = ein oder mehrere Elemente ausgewählt aus den Nichtmetallen, insbesondere den Nichtmetallen der Gruppen 13, 14 und 15 des Periodensystems der Elemente,
x = 0 bis 0,5,
y = 0 Bis 1,
z = 0 bis 1 und
v = 0 bis 1
**dadurch gekennzeichnet,**
**dass** ein Sauerstoffgehalt von ≤ 1 Gew. % bezogen auf das Gesamtgewicht der Verbindung der Formel (I) aufweist.

20. Formkörper umfassend eine Verbindung nach Anspruch 19 oder erhältlich nach einem der Ansprüche 12 bis 18,
**dadurch gekennzeichnet,**
**dass** er bei Temperaturen ≥ 30 K supraleitfähige Eigenschaften zeigt.

21. Verwendung einer Verbindung nach Anspruch 19 oder eines Formkörpers nach Anspruch 20 als Supraleiter.

## Claims

1. A method for producing a compound of the formula (I)
Mg₁₋ₓMS_{y}B_{2-z}Eeᵥ, in which
Me = one or more elements selected from among metals, in particular alkali metals, alkaline earth metals, transition metals, group III metals and rare earth metals,
Ee = one or more elements selected from among non-metals, in particular non-metals of groups 13, 14 and 15 of the periodic table of elements,
x = 0 to 0.5,
y = 0 to 1
z = 0 to 1 and
v = 0 to 1,
**characterised in that**
magnesium hydride and optionally Me hydride or/and Me is reacted with boron and optionally with Ee.

2. A method according to claim 1,
**characterised in that**
MgB₂ is produced by reacting MgH₂ and B.

3. A method for producing a compound of the formula (I)
Mg₁₋ₓMe_{y}B_{2-z}Eeᵥ, in which
Me = one or more elements selected from among metals, in particular alkali metals, alkaline earth metals, transition metals, group III metals and rare earth metals,
Ee = one or more elements selected from among non-metals, in particular non-metals of groups 13, 14 and 15 of the periodic table of elements,
x = 0 to 0.5,
y = 0 to 1
z = 0 to 1 and
v = 0 to 1,
**characterised in that**
an Mg-containing compound and optionally an Me-containing compound is reacted with a B-containing compound and optionally an Ee-containing compound by means of pulse plasma synthesis.

4. A method according to claim 3,
**characterised in that**
the starting materials used are MgH₂ or mixtures of MgH₂ and Mg and optionally Me hydride and/or Me and elemental boron and optionally elemental Ee.

5. A method according to either one of claim 3 or claim 4,
**characterised in that**
MgH₂ is used as one of the starting materials.

6. A method according to any one of the preceding claims,
**characterised in that**
the starting materials are used in the stoichiometry of the product to be produced.

7. A method according to any one of claims 3 to 6,
**characterised in that**
pulses with an intensity of 1 to 2000 A, a length of 1 to 10 ms and a frequency of 1 to 1000 Hz are applied to the starting materials.

8. A method according to any one of the preceding claims,
**characterised in that**
the reaction is performed at a reaction temperature of ≤900°C.

9. A method according to any one of the preceding claims,
**characterised in that**
the reaction is performed at a reaction pressure of 1 to 1000 bar.

10. A method according to any one of the preceding claims,
**characterised in that**
the reaction is performed under an inert gas atmosphere.

11. A method according to any one of the preceding claims,
**characterised in that**
the compound of the formula (I) is produced in powder form.

12. A method for producing a moulding comprising a method according to any one of the preceding claims 1 to 10, furthermore comprising the step of:
producing a moulding from a compound of the formula (I).

13. A method for forming a moulding comprising a method according to claim 11, furthermore comprising the step of:
powder compacting the resultant powder in order to form a moulding.

14. A method according to any one of claims 1 to 10 and 12 to 13,
**characterised in that**
a structure is produced which exhibits ≥50% of theoretical density.

15. A method according to any one of claims 1 to 10 or 12 to 13,
**characterised in that**
a porous structure is produced.

16. A method according to claim 15,
**characterised in that**
a porous structure is obtained by means of pulse plasma synthesis at a pressure of ≤5 bar.

17. A method according to claim 15,
**characterised in that**
the porous structure is obtained by sintering MgB₂ powder.

18. A method for producing an infiltrated porous structure comprising a method according to any one of claims 15 to 17, furthermore comprising the step of:
infiltrating the porous structure with at least one metal and/or metal alloy.

19. A compound of the formula (I)
Mg₁₋ₓMe_{y}B_{2-z}Eeᵥ, in which
Me = one or more elements selected from among metals, in particular alkali metals, alkaline earth metals, transition metals, group III metals and rare earth metals,
Ee = one or more elements selected from among non-metals, in particular non-metals of groups 13, 14 and 15 of the periodic table of elements,
x = 0 to 0.5,
y = 0 to 1,
z = 0 to 1 and
v = 0 to 1,
**characterised in that**
[it] has an oxygen content of ≤1 wt.% relative to the total weight of the compound of the formula (I).

20. A moulding comprising a compound according to claim 19 or obtainable according to any one of claims 12 to 18,
**characterised in that**
it exhibits superconductive properties at temperatures of ≥30 K.

21. Use of a compound according to claim 19 or of a moulding according to claim 20 as a superconductor.

## Revendications

1. Procédé de fabrication d'un composé de formule (I) Mg₁₋ₓMe_{y}B_{2-z}Eeᵥ, dans laquelle
Me = un ou plusieurs éléments choisis parmi les métaux, en particulier les métaux alcalins, les métaux alcalino-terreux, les métaux de transition, les métaux terreux, et les terres rares,
Ee = un ou plusieurs éléments choisis parmi les non-métaux, en particulier les non-métaux des groupes 13, 14 et 15 de la classification périodique des éléments,
x = 0 à 0,5,
y = 0 à 1,
z = 0 à 1 et
v=0 à 1,
**caractérisé en ce que** l'on fait réagir de l'hydrure de magnésium et éventuellement de l'hydrure de Me et/ou Me avec du bore et éventuellement avec Ee.

2. Procédé selon la revendication 1, **caractérisé en ce que** l'on prépare du MgB₂ par réaction de MgH₂ avec B.

3. Procédé de fabrication d'un composé de formule (I) Mg₁₋ₓMe_{y}B_{2-z}Eeᵥ, dans laquelle
Me = un ou plusieurs éléments choisis parmi les métaux, en particulier les métaux alcalins, les métaux alcalino-terreux, les métaux de transition, les métaux terreux, et les métaux des terres rares,
Ee = un ou plusieurs éléments choisis parmi les non-métaux, en particulier les non-métaux des groupes 13, 14 et 15 de la classification périodique des éléments,
x = 0 à 0,5,
y= 0 à 1,
z = 0 à 1 et
v= 0 à 1,
**caractérisé en ce que** l'on fait réagir un composé contenant du Mg et éventuellement un composé contenant du Me avec un composé contenant du B et éventuellement un composé contenant du Ee par synthèse à plasma pulsé.

4. Procédé selon la revendication 3, **caractérisé en ce que** l'on utilise du MgH₂ ou des mélanges de MgH₂ et de Mg et éventuellement de l'hydrure de Me et/ou du Me ainsi que du bore élémentaire et éventuellement du Ee élémentaire comme produits de départ.

5. Procédé selon l'une quelconque des revendications 3 ou 4, **caractérisé en ce que** l'on utilise MgH₂ comme l'un des produits de départ.

6. Procédé selon l'une quelconque des revendications précédentes, **caractérisé en ce que** l'on utilise les produits de départ en quantités stoechiométriques du produit à fabriquer.

7. Procédé selon l'une quelconque des revendications 3 à 6, **caractérisé en ce que** des impulsions d'une force de 1 à 2000 A, d'une longueur de 1 à 10 ms et d'une fréquence de 1 à 1000 Hz sont appliquées aux produits de départ.

8. Procédé selon l'une quelconque des revendications précédentes, **caractérisé en ce que** la conversion est réalisée à une température réactionnelle de ≤ 900°C.

9. Procédé selon l'une quelconque des revendications précédentes, **caractérisé en ce que** la conversion est réalisée à une pression réactionnelle de 1 à 1000 bars.

10. Procédé selon l'une quelconque des revendications précédentes, **caractérisé en ce que** la conversion est réalisée sous une atmosphère de gaz inerte.

11. Procédé selon l'une quelconque des revendications précédentes, **caractérisé en ce que** le composé de formule (I) est fabriqué sous forme de poudre.

12. Procédé de fabrication d'un article moulé, comprenant un procédé selon l'une quelconque des revendications 1 à 10 précédentes, comprenant en outre une étape de fabrication d'un article moulé formé d'un composé de formule (I).

13. Procédé de réalisation d'un article moulé, comprenant un procédé selon la revendication 11, comprenant en outre une étape de compactage de la poudre obtenue, pour réaliser un article moulé.

14. Procédé selon l'une des revendications 1 à 10 et 12 à 13, **caractérisé en ce qu'**une structure est fabriquée, qui présente ≥ 50 % de la densité théorique.

15. Procédé selon l'une quelconque des revendications 1 à 10 ou 12 à 13, **caractérisé en ce qu'**une structure poreuse est fabriquée.

16. Procédé selon la revendication 15, **caractérisé en ce qu'**une structure poreuse est obtenue par synthèse à plasma pulsé à une pression de ≤ 5 bars.

17. Procédé selon la revendication 15, **caractérisé en ce que** la structure poreuse est obtenue par frittage d'une poudre de MgB₂.

18. Procédé de fabrication d'une structure poreuse infiltrée, comprenant un procédé selon l'une quelconque des revendications 15 à 17, comprenant en outre une étape d'infiltration de la structure poreuse avec au moins un métal et/ou un alliage métallique.

19. Composé de formule (I) Mg₁₋ₓMe_{y}B_{2-z}Eeᵥ, dans laquelle
Me = un ou plusieurs éléments choisis parmi les métaux, en particulier les métaux alcalins, les métaux alcalino-terreux, les métaux de transition, les métaux terreux, et les métaux des terres rares,
Ee = un ou plusieurs éléments choisis parmi les non-métaux, en particulier les non-métaux des groupes 13, 14 et 15 de la classification périodique des éléments,
x = 0 à 0,5,
Y = 0 à 1,
z = 0 à 1 et
v= 0 à 1,
**caractérisé en ce qu'**il présente une teneur en oxygène de ≤ 1 % en poids rapportée au poids total du composé de formule (I).

20. Article moulé comprenant un composé selon la revendication 19 ou que l'on peut obtenir selon l'une quelconque des revendications 12 à 18, **caractérisé en ce qu'**il présente des propriétés supraconductrices à une température ≥ 30 K.

21. Utilisation d'un composé selon la revendication 19 ou d'un article moulé selon la revendication 20 comme supraconducteur.
